(19) 

Europäisches Patentamt

European Patent Office

Office européen des brevets

(11) **EP 4 768 958 A1**

(12) **EUROPEAN PATENT APPLICATION**
published in accordance with Art. 153(4) EPC

(43) Date of publication:
**01.07.2026 Bulletin 2026/27**

(21) Application number: **25768474.6**

(22) Date of filing: **16.01.2025**

(51) International Patent Classification (IPC):
*G01R 31/392* (2019.01)   *G01R 31/396* (2019.01)
*G01R 31/382* (2019.01)   *G01R 31/367* (2019.01)
*G01R 31/36* (2020.01)

(52) Cooperative Patent Classification (CPC):
**G01R 31/36; G01R 31/367; G01R 31/382;
G01R 31/392; G01R 31/396**

(86) International application number:
**PCT/KR2025/000957**

(87) International publication number:
**WO 2025/187948 (11.09.2025 Gazette 2025/37)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **06.03.2024 KR 20240031857**

(71) Applicant: **LG Energy Solution, Ltd.
Seoul 07335 (KR)**

(72) Inventors:
• **KIM, Min Jun**
  **Daejeon 34122 (KR)**
• **CHUNG, Mi Kyung**
  **Daejeon 34122 (KR)**
• **KOH, Dong Wook**
  **Daejeon 34122 (KR)**
• **CHUN, Joo Young**
  **Daejeon 34122 (KR)**

(74) Representative: **Plasseraud IP
104 Rue de Richelieu
CS92104
75080 Paris Cedex 02 (FR)**

(54) **BATTERY DIAGNOSTIC DEVICE AND OPERATION METHOD THEREOF**

(57)    A battery diagnosis device according to an embodiment disclosed in this document includes a data acquisition unit that acquires first data related to a voltage and capacity of a reference battery and second data related to a voltage and capacity of a target battery and a controller that fits the first data and the second data to each other so that a value of an objective function related to an error between the first data and the second data is minimized, and predicts a degree of degradation of the target battery based on the fitting result.

FIG.1

**EP 4 768 958 A1**

**Description**

## CROSS-REFERENCE TO RELATED APPLICATION

The present application claims the benefit of the priority of Korean Patent Application No. 10-2024-0031857, filed on March 6, 2024, which is hereby incorporated by reference in its entirety.

## TECHNICAL FIELD

An embodiment disclosed in this document relates to a battery diagnosis device and operating method thereof.

## BACKGROUND ART

Recently, research and development on secondary batteries have been actively conducted. Here, secondary batteries are batteries that can be charged and discharged, and include both conventional Ni/Cd batteries, Ni/MH batteries, and recent lithium ion batteries. Among secondary batteries, lithium ion batteries have the advantage of having much higher energy density than conventional Ni/Cd batteries, Ni/MH batteries, etc. In addition, lithium ion batteries may be manufactured to be small and lightweight, and thus the lithium ion batteries are used as a power source for mobile devices. Recently, the scope of use of the lithium ion batteries has expanded to include a power source for electric vehicles, and the lithium ion batteries are attracting attention as a next-generation energy storage medium.

Since the battery has characteristics that gradually degrades in performance such as capacity degradation as it is used, it is necessary to diagnose a state of the battery and predict the remaining life thereof. In the process of diagnosing the state of the battery and predicting the remaining life thereof, the electrochemical mechanism of the battery can be reflected in more detail by utilizing various factors indicating the state of the battery.

## DISCLOSURE OF THE INVENTION

## TECHNICAL PROBLEM

An objective of the embodiments disclosed in this document is to provide a battery diagnosis device for predicting a degree of battery degradation with high reliability and operating method thereof.

The technical problems of the embodiments disclosed in this document are not limited to the technical problems mentioned above, and other technical problems not mentioned will be clearly understood by those skilled in the art to which the present invention belongs from the description below.

## TECHNICAL SOLUTION

A battery diagnosis device according to an embodiment disclosed in this document may include a data acquisition unit that acquires first data related to a voltage and capacity of a reference battery and second data related to a voltage and capacity of a target battery and a controller that fits the first data and the second data to each other so that a value of an objective function related to an error between the first data and the second data is minimized, and predicts a degree of degradation of the target battery based on the fitting result.

According to an embodiment, each of the first data and the second data may include a first graph and a second graph representing a relationship between the voltage and capacity of the reference battery and the target battery, respectively, and the controller may shift and shrink the first graph and fit the first graph to the second graph.

According to an embodiment, the shift operation may correspond to an operation of moving a capacity axis of the first graph by a setting value, and the shrink operation may correspond to an operation of shrinking the capacity axis of the first graph by a setting ratio.

According to an embodiment, the controller may compute a first mean absolute percent error (MAPE) value between the shifted and shrunk first graph and the second graph, compute a second MAPE value between a first differential graph (dV1/dQ) obtained by differentiating the shifted and shrunk first graph with respect to the capacity and a second differential graph (dV2/dQ) obtained by differentiating the second graph with respect to the capacity, compute a third MAPE value between the shifted and shrunk first graph in a setting section and the second graph in the setting section, compute a fourth MAPE value between the first differential graph (dV1/dQ) in the setting section and the second differential graph (dV2/dQ) in the setting section, and generate a first objective function indicating a degree of error between the shifted and shrunk first graph and the second graph based on the first MAPE value, the second MAPE value, the third MAPE value, and the fourth MAPE value.

According to an embodiment, the first objective function may satisfy Equations 1 and 2 below.

First objective function = (X*first MAPE value) + (Y*second MAPE value) + (Z*(third MAPE value + fourth MAPE value)) [Equation 1]

$$[\text{Equation 2}]$$

$$X = 1$$

$$Y = \tan(\theta), \ (0 < \theta < \frac{\pi}{2})$$

$$Z = \frac{1}{\ln(1+\tan(\theta))}$$

According to an embodiment, the controller may compute a value of the first objective function of each of the shifted and shrunk first graphs while changing the setting value and the setting ratio.

According to an embodiment, the controller may generate a second objective function related to an error between each of the shifted and shrunk first graphs and the second graph, and the second objective function may satisfy Equation 3 below.

Second objective function = first MAPE value + second MAPE value [Equation 3]

According to an embodiment, the controller may diagnose the degree of degradation of the target battery based on the X, Y, Z values, the setting value, and the setting ratio when each of the first objective function and the second objective function has a minimum value.

According to an embodiment, the setting section may correspond to a section in which a sixth phase transition (Ta6) occurring in a charging direction from a cathode of the reference battery appears.

An operating method of a battery diagnosis device according to an embodiment disclosed in this document includes acquiring first data related to a voltage and capacity of a reference battery and second data related to a voltage and capacity of a target battery, fitting the first data and the second data to each other so that a value of an objective function related to an error between the first data and the second data is minimized, and predicting a degree of degradation of the target battery based on the fitting result.

According to an embodiment, each of the first data and the second data may include a first graph and a second graph representing a relationship between the voltage and capacity of the reference battery and the target battery, respectively.

According to an embodiment, the fitting may include performing a shift operation for moving a capacity axis of the first graph by a setting value, performing a shrink operation for shrinking the capacity axis of the first graph by a setting ratio, and generating a first objective function representing a degree of error between the shifted and shrunk first graph and the second graph.

According to an embodiment, the generating of the first objective function may include computing a first mean absolute percent error (MAPE) value between the shifted and shrunk first graph and the second graph, computing a second MAPE value between a first differential graph (dV1/dQ) obtained by differentiating the shifted and shrunk first graph with respect to the capacity and a second differential graph (dV2/dQ) obtained by differentiating the second graph with respect to the capacity, computing a third MAPE value between the first graph in the setting section and the second differential graph in the setting section, computing a fourth MAPE value between the first differential graph (dV1/dQ) in the setting section and the second differential graph (dV2/dQ) in the setting section, and generating the first objective function representing the degree of error between the shifted and shrunk first graph and the second graph based on the first MAPE value, the second MAPE value, the third MAPE value, and the fourth MAPE value.

According to an embodiment, the first objective function may satisfy Equations 1 and 2 below.

First objective function = (X*first MAPE value) + (Y*second MAPE value) + (Z*(third MAPE value + fourth MAPE value)) [Equation 1]

[Equation 2]

$$X = 1,$$

$$Y = \tan(\theta), \quad (0 < \theta < \frac{\pi}{2})$$

$$Z = \frac{1}{\ln(1+\tan(\theta))}$$

According to an embodiment, the predicting of the degree of degradation may include computing a value of the first objective function of each of the shifted and shrunk first graphs while changing the setting value and the setting ratio, generating a second objective function related to an error between each of the shifted and shrunk first graphs and the second graph, and diagnosing a degree of degradation of the target battery based on the X, Y, Z values, the setting value, and the setting ratio when each of the first objective function and the second objective function has a minimum value.

## ADVANTAGEOUS EFFECTS

The battery diagnosis device according to an embodiment disclosed in this document can predict the degree of degradation of the battery by reflecting the electrochemical mechanism of the battery.

## BRIEF DESCRIPTION OF THE DRAWINGS

FIG. 1 is a diagram for describing a battery diagnosis device 1000 according to an embodiment disclosed in this document.
FIG. 2 is a graph for describing data fitting according to an embodiment disclosed in this document.
FIG. 3 is a graph for describing a shift and shrink operation according to an embodiment disclosed in this document.
FIG. 4 is a graph for describing results before and after fitting according to an embodiment disclosed in this document.
FIG. 5 is a graph for describing a differential value according to an embodiment disclosed in this document.
FIG. 6 is a flowchart for describing an operation of a battery diagnosis device according to an embodiment disclosed in this document.

## MODE FOR CARRYING OUT THE INVENTION

Hereinafter, the embodiments disclosed in this document will be described in detail with exemplary drawings. When adding reference numerals to components of each drawing, it should be noted that the same components are given the same reference numerals as much as possible even if they are illustrated in different drawings. In addition, in describing the embodiments disclosed in this document, when it is determined that a specific description of a related known configuration or function interferes with the understanding of the embodiments disclosed in this document, the detailed description thereof will be omitted.

In describing the components of the embodiments disclosed in this document, terms such as first, second, A, B, (a), (b), etc. may be used. These terms are only intended to distinguish a component from another component, and the nature, order, or sequence of the component is not limited by the term. In addition, unless otherwise defined, all terms used herein, including technical or scientific terms, have the same meaning as commonly understood by a person of ordinary skill in the technical field to which the embodiments disclosed in this document belong. Terms defined in commonly used dictionaries should be interpreted as having meanings consistent with their meaning in the context of the relevant technology, and shall not be interpreted in an idealized or overly formal sense unless expressly defined in this application.

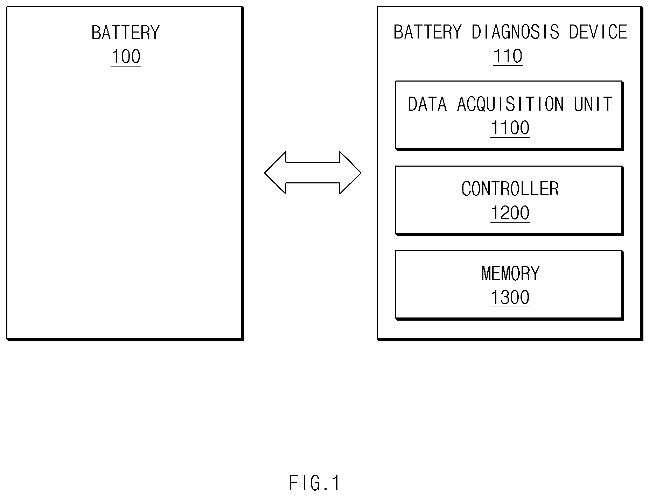

FIG. 1 is a diagram for describing a battery diagnosis device 1000 according to an embodiment disclosed in this document.

A battery 100 may be implemented as a battery pack, a battery module, a battery cell, etc. When the battery 100 is implemented in units of battery packs, the battery 100 may be configured to include a plurality of battery modules (not illustrated). In this case, each of the battery modules (not illustrated) may be configured to include a plurality of battery cells (not illustrated), and the battery cells (not illustrated) may be lithium ion (Li-ion) batteries, nickel-hydrogen (Ni-H) batteries, etc., but are not limited to these examples.

The battery 100 may be configured to supply power to a target device (not illustrated), and to this end, the battery 100 may be electrically connected to the target device (not illustrated). Here, the target device (not illustrated) may include an electrical, electronic or mechanical device that operates by receiving power from the battery 100, and for example, the target device (not illustrated) may be an electric vehicle (EV), a two-wheeled electric vehicle such as an electric scooter, etc., but is not limited thereto. In addition, when the target device is the two-wheeled electric vehicle such as the electric scooter, the battery 100 mounted on the two-wheeled electric vehicle may be replaced through a battery swapping station (BSS).

The battery diagnosis device 1000 may diagnose the battery 100 based on data related to the voltage and capacity of the battery 100 and predict a degree of degradation of the battery 100. Referring to FIG. 1, the battery diagnosis device 1000 may include a data acquisition unit 1100, a controller 1200, and a memory 1300.

The data acquisition unit 1100 may acquire data related to the voltage and capacity of the battery 100. According to an embodiment, the data acquisition unit 1100 may acquire first data related to the voltage and capacity of a reference battery and second data related to the voltage and capacity of a target battery. Here, the target battery may be a battery whose degree of degradation is to be diagnosed, and the reference battery may be a battery that is a target of determination of the degree of degradation of the target because the reference battery has not degraded, and may be, for example, a shipped battery, but is not limited to this example.

According to an embodiment, the first data may include a first graph representing the voltage of the reference battery according to the capacity of the reference battery. In addition, the second data may include a second graph representing the voltage of the target battery according to the capacity of the target battery. Here, the first graph may include data acquired through experiments/developments of the reference battery, and the second graph may include, but is not limited to, beginning of life (BOL) data and/or middle of life (MOL) data of the target battery.

According to an embodiment, the data acquisition unit 1100 may acquire data related to a graph representing the voltage of the battery according to the capacity of the battery 100 by charging and discharging the battery 100. In this case, the data acquisition unit 1100 may further include various circuits for applying voltage and/or current to the battery 100 or performing a charging/discharging operation of the battery 100 and a processor for processing the acquired data.

According to an embodiment, the data acquisition unit 1100 may indirectly acquire data related to a graph showing voltages according to the capacity of the battery 100. In this case, the data acquisition unit 1100 may further include a communication module for communicating with the battery 100 in a wired manner and/or wirelessly.

The controller 1200 may control the overall operation of the battery diagnosis device 1000. Here, the controller 1200 may execute instructions or software to control at least one other component (e.g., hardware or software) of the battery diagnosis device 1000, or perform operations such as processing and/or computing various data.

The controller 1200 may predict the degree of degradation of the battery 100 based on data related to the voltage and capacity of the battery 100 acquired by the data acquisition unit 1100.

According to an embodiment, the controller 1200 may fit data related to the capacity and voltage of the reference battery to data related to the voltage and capacity of the target battery, and predict the degree of degradation of the target battery based on the fitting result.

Here, the controller 1200 may fit the first graph representing the voltage of the reference battery according to the capacity of the reference battery to the second graph representing the voltage of the target battery according to the capacity of the target battery. In the process of fitting the first graph to the second graph, the controller 1200 may fit the first graph to the second graph so that a value of a first objective function related to a degree of error between the first graph and the second graph is minimized.

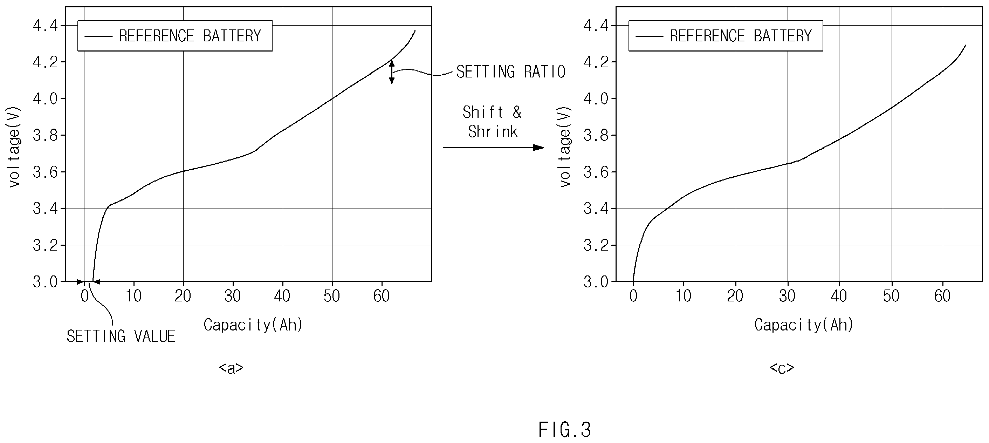

The controller 1200 may shift and shrink the first graph, which represents the voltage of the reference battery according to the capacity of the reference battery, and fit the first graph to the second graph. Specific details related to this will be described below in the description of FIG. 3.

The controller 1200 may fit the first graph to the second graph while variously changing a setting value, which is a degree to which the first graph is shifted and a setting ratio, which is a ratio at which the first graph is shrunk, and then compute the value of the first objective function related to an error between each of the shifted and shrunk first graphs and the second graph.

The controller 1200 may compute the value of the first objective function related to the error between the shifted and shrunk first graph and the second graph by reflecting various variables.

According to an embodiment, the controller 1200 may compute the value of the objective function based on a difference between the voltage of the reference battery and the voltage of the target battery by utilizing the first graph representing the voltage according to the capacity of the shifted and shrunk reference battery and the second graph representing the voltage according to the capacity of the target graph. Specifically, the controller 1200 may compute a first MAPE value, which is a mean absolute percent error (MAPE) between the first graph of the shifted and shrunk reference battery and the second graph of the target battery.

According to an embodiment, the controller 1200 may compute the value of the objective function based on a difference between a first differential value obtained by differentiating the voltage of the reference battery with respect to the capacity and a second differential value obtained by differentiating the voltage of the target battery with respect to the capacity by utilizing a first differential graph (dV1/dQ) obtained by differentiating the first graph representing the voltage according to the capacity of the shifted and shrunk reference battery with respect to the capacity and a second differential graph (dV2/dQ) obtained by differentiating the second graph representing the voltage according to the capacity of the target battery with respect to the capacity. Specifically, the controller 1200 may compute a second MAPE value, which is a mean absolute percent error between the first differential graph and the second differential graph.

According to an embodiment, the controller 1200 may compute a third MAPE value, which is a mean absolute percent error between the first graph representing the voltage according to the capacity of the shifted and shrunk reference battery and the second graph representing the voltage according to the capacity of the target battery in a setting section.

According to an embodiment, the controller 1200 may compute the value of the objective function based on the difference between the first differential graph (dV1/dQ) obtained by differentiating the voltage the shifted and shrunk reference battery with respect to the capacity and the second differential graph (dV2/dQ) obtained by differentiating the voltage of the target battery with respect to the capacity in the setting section. Specifically, the controller 1200 may compute a fourth MAPE value, which is a mean absolute percent error between the first differential graph (dV1/dQ) and the second differential graph (dV2/dQ) in the setting section.

Here, the setting section may correspond to a section in which a sixth phase transition (Transition anode 6; Ta6) occurring at the cathode of the reference battery in the charging direction appears, but is not limited to this example. That is, the setting section does not necessarily have to be the section where the sixth phase transition appears, and may correspond to a section where a peak at which a change in voltage according to a phase transition is the largest appears in the first differential graph of the reference battery.

Here, the mean absolute percentage error is an indicator of how much the difference is between an actual value and an estimated value, and may be defined as a value obtained by converting a mean absolute error (MAE), which is an average value obtained by adding up the absolute values of the errors, into a percentage. The controller 1200 may compute the value of the objective function that minimizes the error between the first graph and the second graph in consideration of the first MAPE value, the second MAPE value, the third MAPE value, and the fourth MAPE value in a capacity range of the reference battery and the target battery.

The controller 1200 may generate a first objective function that represents the degree of error between the shifted and shrunk first graph and the second graph based on the first MAPE value, the second MAPE value, the third MAPE value, and the fourth MAPE value. According to one embodiment, the first objective function may satisfy the following equations.

First objective function = (X*first MAPE value) + (Y*second MAPE value) + (Z*(third MAPE value + fourth MAPE value)) [Equation 1]

$$[Equation\ 2]$$

$$X = 1$$

$$Y = \tan(\theta), \quad (0 < \theta < \frac{\pi}{2})$$

$$Z = \frac{1}{ln(1+\tan(\theta))}$$

According to an embodiment, the first objective function may include a first weight X assigned to the first MAPE value, a second weight Y assigned to the second MAPE value, and a third weight Z assigned to the third MAPE value and the fourth MAPE value. Here, the second weight and the third weight may vary depending on a value of theta $\theta$.

That is, when the first graph is shifted and shrunk by a setting value and a setting ratio, the first objective function may be a function that uses the value of theta $\theta$ as a variable. The controller 1200 may compute the value of the first objective function while changing the value of theta $\theta$, and acquire the value of theta $\theta$ when the value of the first objective function is minimized.

The controller 1200 may acquire the value of the first objective function and the value of theta when the value of the first objective function is minimized while changing the setting ratio and the set. That is, the controller 1200 may shift and shrink the first graph by changing the setting ratio and the setting value, and acquire the value of the first objective function between the shifted and shrunk first graph and the second graph and the value of theta when the value of the first objective function is minimized.

The controller 1200 may generate a second objective function based on the first MAPE value and the second MAPE value. Here, the second objective function may satisfy the following equation.

Second objective function = first MAPE value + second MAPE value [Equation 3]

The controller 1200 may compute the X, Y, and Z values based on the value of theta when each of the first objective function and the second objective function is minimized, and may predict the degree of degradation of the target battery based on the computed X, Y, and Z values, the setting value, and the setting ratio.

The memory 1300 may store various data, for example, the first data and second data, a plurality of graphs and equations of graphs, the degree of degradation of the battery corresponding to the setting value and the setting ratio, a plurality of weights computed, etc. described above.

According to an embodiment, the memory 1300 may include a volatile memory device such as a static random access memory (SRAM) or a dynamic random access memory (DRAM), or a nonvolatile memory device such as a read only memory (ROM), a programmable ROM (PROM), or a flash memory.

Referring to FIG. 1, the memory 1300 is illustrated as being included in the battery diagnosis device 1000, but is not limited thereto, and the memory 1300 may be configured to be located outside the battery diagnosis device 1000 and store data transmitted by the battery diagnosis device 1000.

According to an embodiment, the battery diagnosis device 1000 may be configured to be formed integrally with the battery 100 and/or included inside the battery 100. In this case, the battery diagnosis device 1000 may be configured to be included in a battery management system (BMS) that controls the battery 100.

According to an embodiment, the battery diagnosis device 1000 may be formed separately from the battery 100. In this case, the battery diagnosis device 1000 may be configured to diagnose the battery 100 by being connected to the battery 100 through a wired and/or wireless network, etc.

According to an embodiment, the battery diagnosis device 1000 may be configured to transmit the degree of degradation of the battery 100 to an external device (e.g., a cloud server or a user terminal) or provide a notification. The cloud server may be configured to provide information related to the degree of degradation of the battery 100 to a user, and a user terminal may include a terminal such as a personal computer (PC) or a smartphone. When the degree of degradation of the battery 100 reaches a value lower than a preset reference value, the battery diagnosis device 1000 may transmit a notification to the user terminal instructing the user to replace the battery 100 and/or diagnose the battery 100 through the user terminal.

According to an embodiment, the battery diagnosis device 1000 may be included in a battery exchange station (BSS). Here, the battery exchange station may be an integrated system that has a slot into which the battery 100 can be inserted and can charge the inserted battery 100.

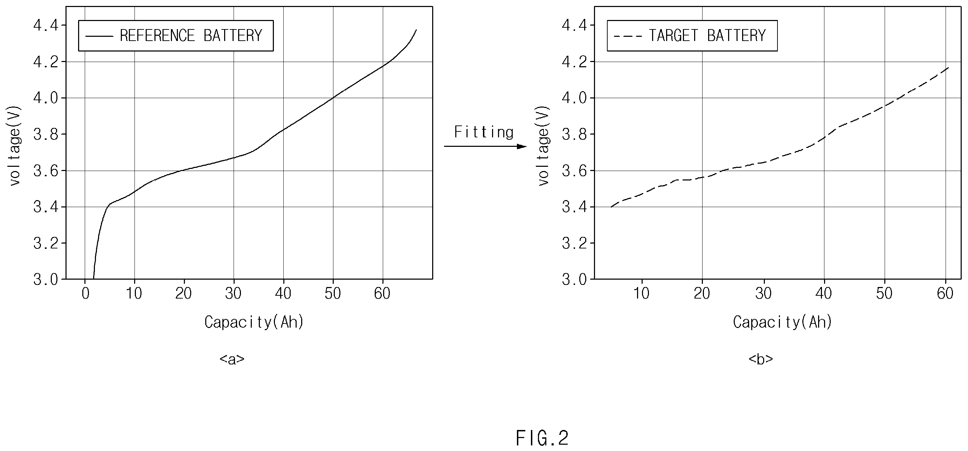

FIG. 2 is a graph for describing data fitting according to an embodiment disclosed in this document.

Referring to FIG. 2, the first data related to the voltage and capacity of the reference battery and the second data related to the voltage and capacity of the target battery are illustrated.

According to an embodiment, the first data related to the voltage and capacity of the reference battery may include a first graph (a) representing the voltage of the reference battery according to the capacity of the reference battery. Here, the first graph (a) may be a graph in which the horizontal axis represents capacity (Ah) of the reference battery and the vertical axis represents open circuit voltage (OCV) of the reference battery.

According to an embodiment, the second data related to the voltage and capacity of the target battery may include a second graph (b) representing the voltage of the target battery according to the capacity of the target battery. Here, the second graph (b) may be a graph in which the horizontal axis represents the capacity (Ah) of the target battery and the vertical axis represents the open circuit voltage (OCV) of the target battery. Here, the target battery may correspond to a battery in a beginning of life (BOL) state in which it is installed in an electric vehicle or a two-wheeled electric vehicle and begins operation, or a battery in middle of life ((MOL) in which it is actually operated and degraded, and the voltage of the target battery with respect to the capacity of the target battery may gradually change as degradation progresses.

As described above in the description of FIG. 1, the controller 1200 (see FIG. 1) nay fit the first graph (a) to the second graph (b). A specific fitting process will be described below in the detailed description of FIGS. 3 to 5.

FIG. 3 is a graph for describing a shift and shrink operation according to an embodiment disclosed in this document.

Referring to FIG. 3, the controller 1200 (see FIG. 1) may shift and shrink the first graph (a) to fit the first graph (a) to the second graph (b) (see FIG. 2).

According to an embodiment, the shift may be related to a phenomenon in which a capacity axis of the first graph (a), which is a graph of an open circuit voltage (OCV) versus capacity of the battery 100 (see FIG. 1), translates in a positive direction in the first graph (a) when a loss of lithium inventory (LLI) occurs due to a phenomenon such as thickening of a solid electrolyte interphase (SEI) layer formed on a surface of a cathode of the target battery, decomposition of an electrolyte, or lithium plating, which consumes lithium ions. That is, the controller 1200 may shift the first graph (a), which represents the voltage according to the capacity of the reference battery, by a setting value to fit the first graph (a) to the second graph (b) (see FIG. 2), which represents the voltage according to the capacity of the target battery, and predict the degree of degradation of the target battery corresponding to the setting value. Here, the setting value may be set and changed in various ways.

According to one embodiment, the shrink may be related to a phenomenon in which a capacity axis of the second graph (b) (see FIG. 2), which is a graph of the open circuit voltage (OCV) versus capacity of the battery 100, is reduced when loss of active material occurs due to causes such as being affected by the degree of disorder of a crystal structure inside the battery 100 and/or destruction or loss of particles of a cathode and anode of the battery 100. That is, the controller 1200 may shrink the first graph (a) representing the voltage according to the capacity of the reference battery by a setting ratio and fits the first graph (a) to the second graph (b) (see FIG. 2) representing the voltage according to the capacity of the target battery, and may predict the degree of degradation of the target battery corresponding to the setting ratio. Similarly, the setting ratio may also be set and changed to have various values.

The controller 1200 may generate a shifted and shrunk first graph (c) by variously changing the setting value and setting ratio described above.

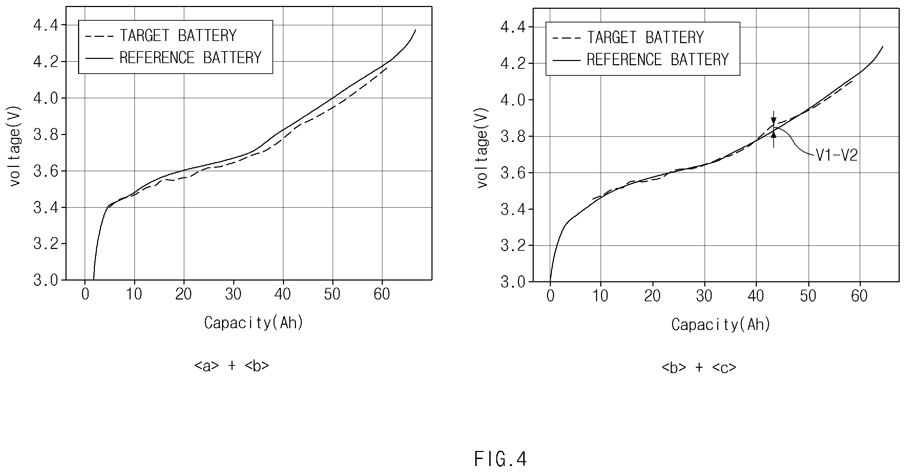

FIG. 4 is a graph for describing the results before and after fitting according to an embodiment disclosed in this document.

The graph illustrated on the left thereof is a graph that illustrates the first graph (a) and the second graph (b) illustrated in FIG. 2 on one coordinate plane. Here, the horizontal axis represents the capacity of the reference battery and the target battery, and the vertical axis represents the open circuit voltage of the reference battery and the target battery. Here, the first graph (a) is a graph before the shift and shrink operation described with reference to FIG. 3 is performed, and there is a large difference in voltage value from the second graph (b) representing the voltage according to the capacity of the target battery.

The controller 1200 (see FIG. 1) may fit the first graph (a) to the second graph (b) by performing the shift and shrink operation described with reference to FIG. 3. Here, the graph depicted on the right thereof is a graph that illustrates a shift and shrink first graph (c) illustrated in FIG. 3 and the second graph (b) illustrated in FIG. 2 on one coordinate plane. Similarly, the horizontal axis represents the capacity of the reference battery and the target battery, and the vertical axis represents the open circuit voltage of the reference battery and the target battery.

According to an embodiment, the controller 1200 may shift and shrink the first graph (a) to fit the first graph (a) to the second graph (b). Referring to the graph illustrated on the right, it can be confirmed that a voltage difference between the reference battery and target battery has decreased compared to the graph illustrated on the left.

According to an embodiment, the controller 1200 may compute a first MAPE value, which is a mean absolute percent error of the voltage difference (V1 - V2) between the shifted and shrunk first graph (c) and the second graph (b). Here, the controller 1200 may compute the first MAPE value in the entire range of capacity (e.g., 0Ah to 100Ah) and/or in a specific range, and a process of computing the first MAPE value is related to general mathematical content, and thus a detailed description thereof is omitted.

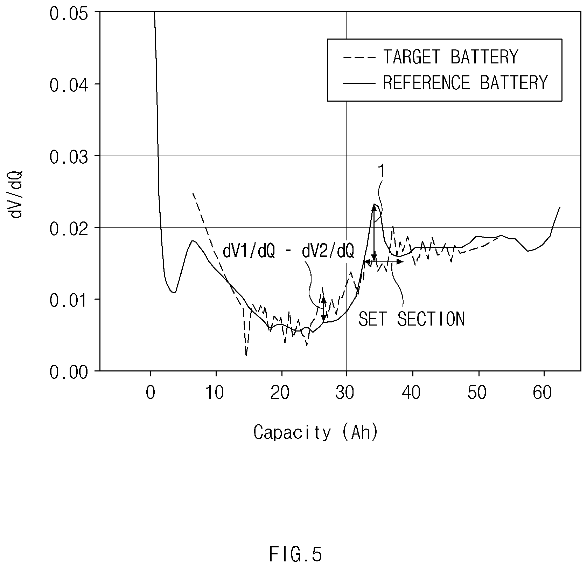

FIG. 5 is a graph for describing a differential value according to an embodiment disclosed in this document.

The controller 1200 (see FIG. 1) may differentiate the shifted and shrunk first graph (c). The controller 1200 may generate a first differential graph obtained by differentiating the shifted and shrunk first graph (c) with respect to capacity.

The controller 1200 may differentiate the second graph (b). The controller 1200 may generate a second differential graph obtained by differentiating the second graph (b) with respect to capacity.

Referring to FIG. 5, the horizontal axis represents the capacity, and the vertical axis may represent a value (dV/dQ) obtained by differentiating the open circuit voltage of each of the reference battery and the target battery with respect to the capacity.

According to an embodiment, the controller 1200 may compute a second MAPE value, which is a mean absolute percent error of a difference (dV1/dQ - dV2/dQ) between the first differential graph and the second differential graph. Here, the controller 1200 may compute the second MAPE value in the entire range of the capacity (e.g., 0Ah to 100Ah) and/or in a specific range, and the process of computing the second MAPE value is related to general mathematical content, and thus a detailed description thereof will be omitted.

The controller 1200 may compute a third MAPE value, which is a mean absolute percent error of the difference between the first graph and the second graph in a setting section. Here, the process of computing the third MAPE value is related to general mathematical content, and thus a detailed description thereof will be omitted.

The controller 1200 may compute a fourth MAPE value, which is a means absolute percent error of the difference (dV1/dQ - dV2/dQ) between the first differential graph and the second differential graph in the setting section. Similarly, the process of obtaining the mean square root error is related to general mathematical content, and thus a detailed description thereof will be omitted.

According to an embodiment, the setting section may be identified based on a differential graph obtained by differentiating the graph of the voltage versus capacity of the battery 100 (see FIG. 1) with respect to the capacity. Specifically, the setting section may be identified based on a plurality of peaks appearing in the differential graph of the battery 100 in the charging direction of the battery 100, that is, in the direction in which the capacity of the battery 100 increases. Each of the plurality of peaks appearing in the differential graph of the battery 100 may correspond to each of points where the phase transition occurs in the battery 100. According to an embodiment, the setting section may be a section including a peak (Transition Anode 6; Ta6) where the sixth phase transition occurring at the cathode of the battery 100 in the charging direction of the battery 100 occurs, but is not limited to this example.

According to an embodiment, the controller 1200 may identify a point having the highest peak in the differential graph of the battery 100. Here, the highest peak has the greatest intensity among a plurality of peaks identified based on the differential graph of the battery 100. The controller 1200 may estimate a change in voltage due to the degradation of the anode and the cathode of the battery 100 and/or irreversible lithium loss based on the voltage of the battery at the peak having the greatest intensity and the differential value dV/dQ obtained by differentiating the voltage with respect to the capacity, etc.

According to an embodiment, the controller 1200 may identify a capacity section including the maximum value and minimum value of the identified highest peak. The controller 1200 may identify a peak 1 having the strongest intensity in the first differential graph of the reference battery, and may identify a setting section including the maximum value and minimum value of the peak 1. The controller 1200 may compute the third MAPE value and the fourth MAPE value based on the first graph, the second graph, the first differential graph, and the second differential graph of the reference battery in the setting section illustrated in FIG. 5.

The controller 1200 may compute values of each of the first objective function and the second objective function while changing the setting value, the setting ratio, and the theta value until the values of the first objective function and the second objective function described above are minimized based on the computed first MAPE value, the second MAPE value, the third MAPE value, and the fourth MAPE value. The controller 1200 may store X, Y, and Z values according to the setting value, the setting ratio, and the theta value when the values of each of the first objective function and the second objective function is minimized in the memory 1300 (see FIG. 1) .

The controller 1200 may predict the degree of degradation of the target battery based on the X, Y, and Z values when the value of the first objective function is minimized and the setting value and setting ratio when the value of the second objective function is minimized. Here, the X, Y, and Z values and the setting value, and the setting ratio may vary depending on the type of vehicle, for example.

The battery diagnosis device 1000 (see FIG. 1) according to an embodiment disclosed in this document may fit data in consideration of a second root mean square error and a third root mean square error. That is, the battery diagnosis device 1000 may diagnose the degree of degradation of the battery 100 in consideration of the amount of change in voltage relative to the capacity and the amount of change in voltage relative to the capacity in a specific section as well as the change in voltage relative to the capacity of the battery 100. Since the amount of change in voltage relative to the capacity of the battery 100 and the amount of change in voltage relative to the capacity in a specific section of the battery 100 may represent data related to the electrical and chemical mechanisms of the battery 100, more advanced data fitting is possible when various variables are reflected in the objective function.

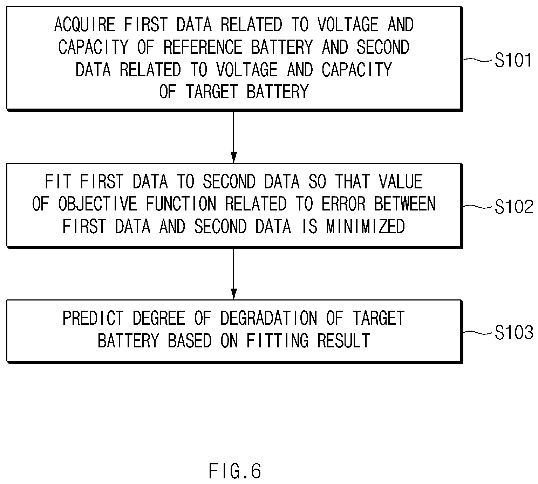

FIG. 6 is a flowchart for describing an operation of a battery diagnosis device according to an embodiment disclosed in this document.

In step S101, the battery diagnosis device 1000 (see FIG. 1) may acquire first data related to the voltage and capacity of a reference battery and second data related to the voltage and capacity of a target battery.

According to an embodiment, the first data may include a first graph (a) (see FIG. 2) representing a relationship between the voltage and capacity of the reference battery, and the second data may include a second graph (b) (see FIG. 2) representing a relationship between the voltage and capacity of the target battery. That is, the first graph (a) may be a graph in which the horizontal axis represents the capacity (Ah) of the reference battery and the vertical axis represents the open circuit voltage (OCV) of the reference battery, and the second graph (b) may be a graph in which the horizontal axis represents the capacity (Ah) of the target battery and the vertical axis represents the open circuit voltage (OCV) of the target battery. Here, the first graph may include data obtained through experiments/developments of the reference battery and the second graph may include beginning of life (BOL) data and/or middle of life (MOL) data of the target battery, but are not limited thereto.

In step S102, the battery diagnostic device 1000 may fit the first data to the second data so that the value of the first objective function indicating the degree of error between the first data and the second data is minimized.

According to an embodiment, the battery diagnosis device 1000 may shift and shrink the first graph to fit the first data to the second data. Here, the shift may be related to an operation of moving the capacity axis of the first graph by a setting value, and the shrink may be related to an operation of shrinking the capacity axis of the first graph by a setting ratio.

According to an embodiment, the battery diagnosis device 1000 may compute a first mean absolute percent error (MAPE) value between the shifted and shrunk first graph and the second graph, compute a second MAPE value between a first differential graph (dV1/dQ) obtained by differentiating the shifted and shrunk first graph with respect to the capacity and a second differential graph obtained by differentiating the second graph with respect to the capacity, compute a third MAPE value between the first graph in a setting section and the second differential graph in a setting section, and compute a fourth MAPE value between the first differential graph (dV1/dQ) in the setting section and a second differential graph (dV2/dQ) in the setting section.

According to an embodiment, the battery diagnosis device 1000 may generate a first objective function representing the degree of error between the shifted and shrunk first graph and the second graph based on the first MAPE value, the second MAPE value, the third MAPE value, and the fourth MAPE value.

According to an embodiment, the first objective function may satisfy Equation 1 and Equation 2 described above.

In step S103, the battery diagnosis device 1000 may predict a degree of degradation of the target battery based on the fitting result.

According to an embodiment, the battery diagnosis device 1000 may compute the value of the first objective function of each of the shifted and shrunk first graphs while changing a setting value and a setting ratio.

According to an embodiment, the battery diagnosis device 1000 may generate a second objective function. Here, the second objective function may satisfy Equation 3 described above.

According to an embodiment, the battery diagnostic device 1000 may predict the degree of degradation of the target battery based on the X, Y, Z values, the setting value, and the setting ratio when each of the first objective function and the second objective function has a minimum value.

In the above, all components constituting the embodiment have been described as being combined or operated by being combined as one, but is not necessarily limited to this embodiment, and within the scope of the purpose, all components may be operated by being selectively combined as one or more. In addition, the terms "include," "configure," or "have" described above, unless specifically stated to the contrary, mean that the corresponding component can be inherent, and therefore should be interpreted as being able to include other components rather than excluding other components.

The above description is merely an example of the technical idea disclosed in this document, and those with ordinary skill in the technical field to which the embodiments disclosed in this document belong may make various modifications and variations without departing from the essential characteristics of the embodiments disclosed in this document.

Therefore, the embodiments disclosed in this document are not intended to limit the technical idea disclosed in this document, but rather to explain them, and the scope of the technical idea disclosed in this document is not limited by these embodiments. The scope of protection of the technical idea disclosed in this document should be interpreted by the claims below, and all technical ideas within the scope equivalent to the claims should be interpreted as being included in the scope of rights of this document.

[Description of reference numerals]

100: battery
1000: battery diagnostic device
1100: data acquisition unit
1200: controller
1300: memory

**Claims**

1. A battery diagnosis device comprising:

   a data acquisition unit that acquires first data related to a voltage and capacity of a reference battery and second data related to a voltage and capacity of a target battery; and
   a controller that fits the first data and the second data to each other so that a value of an objective function related to an error between the first data and the second data is minimized, and predicts a degree of degradation of the target battery based on the fitting result.

2. The battery diagnosis device of claim 1, wherein each of the first data and the second data includes a first graph and a second graph representing a relationship between the voltage and capacity of the reference battery and the target battery, respectively, and
   the controller shifts and shrinks the first graph and fit the first graph to the second graph.

3. The battery diagnosis device of claim 2, wherein the shift operation corresponds to an operation of moving a capacity axis of the first graph by a setting value, and

the shrink operation corresponds to an operation of shrinking the capacity axis of the first graph by a setting ratio.

4. The battery diagnosis device of claim 2, wherein the controller

computes a first mean absolute percent error (MAPE) value between the shifted and shrunk first graph and the second graph,

computes a second MAPE value between a first differential graph (dV1/dQ) obtained by differentiating the shifted and shrunk first graph with respect to the capacity and a second differential graph (dV2/dQ) obtained by differentiating the second graph with respect to the capacity,

computes a third MAPE value between the shifted and shrunk first graph in a setting section and the second graph in the setting section,

computes a fourth MAPE value between the first differential graph (dV1/dQ) in the setting section and the second differential graph (dV2/dQ) in the setting section, and

generates a first objective function indicating a degree of error between the shifted and shrunk first graph and the second graph based on the first MAPE value, the second MAPE value, the third MAPE value, and the fourth MAPE value.

5. The battery diagnosis device of claim 4, wherein the first objective function satisfies Equations 1 and 2 below,

First objective function = (X*first MAPE value) + (Y*second MAPE value) + (Z*(third MAPE value + fourth MAPE value)),　　　　　　　　　　　　　　　　　　　　　　　　　　[Equation 1]

[Equation 2]

$$X = 1$$

$$Y = \tan(\theta), \quad (0 < \theta < \frac{\pi}{2})$$

$$Z = \frac{1}{ln(1+\tan(\theta))}.$$

6. The battery diagnosis device of claim 4, wherein the controller computes a value of the first objective function of each of the shifted and shrunk first graphs while changing the setting value and the setting ratio.

7. The battery diagnosis device of claim 6, wherein the controller generates a second objective function related to an error between each of the shifted and shrunk first graphs and the second graph, and the second objective function satisfies Equation 3 below, Second objective function = first MAPE value + second MAPE value.　　　　　　　　　　　[Equation 3]

8. The battery diagnosis device of claim 7, wherein the controller diagnoses the degree of degradation of the target battery based on the X, Y, Z values, the setting value, and the setting ratio when each of the first objective function and the second objective function has a minimum value.

9. The battery diagnosis device of claim 4, wherein the setting section corresponds to a section in which a sixth phase transition (Ta6) occurring in a charging direction from a cathode of the reference battery appears.

10. An operating method of a battery diagnosis device, the operating method comprising:

acquiring first data related to a voltage and capacity of a reference battery and second data related to a voltage and capacity of a target battery;

fitting the first data and the second data to each other so that a value of an objective function related to an error between the first data and the second data is minimized; and

predicting a degree of degradation of the target battery based on the fitting result.

11. The operating method of claim 10, wherein each of the first data and the second data includes a first graph and a second graph representing a relationship between the voltage and capacity of the reference battery and the target battery, respectively.

12. The operating method of claim 11, wherein the fitting includes:

performing a shift operation for moving a capacity axis of the first graph by a setting value;
performing a shrink operation for shrinking the capacity axis of the first graph by a setting ratio; and
generating a first objective function representing a degree of error between the shifted and shrunk first graph and the second graph.

13. The operating method of claim 12, wherein the generating of the first objective function includes:

computing a first mean absolute percent error (MAPE) value between the shifted and shrunk first graph and the second graph;
computing a second MAPE value between a first differential graph (dV1/dQ) obtained by differentiating the shifted and shrunk first graph with respect to the capacity and a second differential graph (dV2/dQ) obtained by differentiating the second graph with respect to the capacity;
computing a third MAPE value between the first graph in the setting section and the second differential graph in the setting section;
computing a fourth MAPE value between the first differential graph (dV1/dQ) in the setting section and the second differential graph (dV2/dQ) in the setting section; and
generating the first objective function representing the degree of error between the shifted and shrunk first graph and the second graph based on the first MAPE value, the second MAPE value, the third MAPE value, and the fourth MAPE value.

14. The operating method of claim 13, wherein the first objective function satisfies Equations 1 and 2 below,

First objective function = (X*first MAPE value) + (Y*second MAPE value) + (Z*(third MAPE value + fourth MAPE value)) [Equation 1]

$$[\text{Equation 2}]$$
$$X = 1$$
$$Y = \tan(\theta), \quad (0 < \theta < \frac{\pi}{2})$$
$$Z = \frac{1}{ln(1+\tan(\theta))}.$$

15. The operating method of claim 13, wherein the predicting of the degree of degradation includes:

computing a value of the first objective function of each of the shifted and shrunk first graphs while changing the setting value and the setting ratio;
generating a second objective function related an error between each of the shifted and shrunk first graphs and the second graph; and
diagnosing a degree of degradation of the target battery based on the X, Y, Z values, the setting value, and the setting ratio when each of the first objective function and the second objective function has a minimum value.

BATTERY
100

BATTERY DIAGNOSIS DEVICE
110

DATA ACQUISITION UNIT
1100

CONTROLLER
1200

MEMORY
1300

FIG.1

<a>

<b>

FIG.2

EP 4 768 958 A1

FIG.3

EP 4 768 958 A1

<a> + <b>

<b> + <c>

FIG.4

FIG.5

ACQUIRE FIRST DATA RELATED TO VOLTAGE AND
CAPACITY OF REFERENCE BATTERY AND SECOND
DATA RELATED TO VOLTAGE AND CAPACITY
OF TARGET BATTERY ～S101

FIT FIRST DATA TO SECOND DATA SO THAT VALUE
OF OBJECTIVE FUNCTION RELATED TO ERROR BETWEEN
FIRST DATA AND SECOND DATA IS MINIMIZED ～S102

PREDICT DEGREE OF DEGRADATION OF TARGET
BATTERY BASED ON FITTING RESULT ～S103

FIG.6

## INTERNATIONAL SEARCH REPORT

| International application No. |
| --- |
| **PCT/KR2025/000957** |

**A. CLASSIFICATION OF SUBJECT MATTER**

**G01R 31/392**(2019.01)i; **G01R 31/396**(2019.01)i; **G01R 31/382**(2019.01)i; **G01R 31/367**(2019.01)i; **G01R 31/36**(2006.01)i

According to International Patent Classification (IPC) or to both national classification and IPC

**B. FIELDS SEARCHED**

Minimum documentation searched (classification system followed by classification symbols)

G01R 31/392(2019.01); G01R 31/36(2006.01); G01R 31/3835(2019.01); G01R 31/389(2019.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 전압(voltage), 용량(capacity), 함수(function), 피팅(fitting), 진단 (diagnosing)

**C. DOCUMENTS CONSIDERED TO BE RELEVANT**

| Category* | Citation of document, with indication, where appropriate, of the relevant passages | Relevant to claim No. |
| --- | --- | --- |
| Y | JP 2023-140942 A (HITACHI LTD.) 05 October 2023 (2023-10-05)<br>See paragraphs [0018]-[0071], claim 1 and figures 1-9. | 1-15 |
| Y | JP 2023-051292 A (YOKOGAWA ELECTRIC CORP. et al.) 11 April 2023 (2023-04-11)<br>See paragraphs [0028]-[0029] and figure 5. | 1-15 |
| A | KR 10-2022-0128828 A (KUMOH NATIONAL INSTITUTE OF TECHNOLOGY INDUSTRY-ACADEMIC COOPERATION FOUNDATION) 22 September 2022 (2022-09-22)<br>See paragraphs [0045]-[0081] and figures 1-3. | 1-15 |
| A | KR 10-2010-0019249 A (LG CHEM, LTD.) 18 February 2010 (2010-02-18)<br>See paragraphs [0027]-[0143] and figures 1-10. | 1-15 |
| A | US 2020-0386820 A1 (ADVANCED MEASUREMENT TECHNOLOGY INC.) 10 December 2020 (2020-12-10)<br>See paragraphs [0023]-[0063] and figures 1-7. | 1-15 |

☐ Further documents are listed in the continuation of Box C.　　☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **18 April 2025** | **18 April 2025** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2025/000957**

| Patent document cited in search report | | | Publication date (day/month/year) | Patent family member(s) | | | Publication date (day/month/year) |
|---|---|---|---|---|---|---|---|
| JP | 2023-140942 | A | 05 October 2023 | WO | 2023-181589 | A1 | 28 September 2023 |
| JP | 2023-051292 | A | 11 April 2023 | CN | 115877216 | A | 31 March 2023 |
| | | | | EP | 4166965 | A1 | 19 April 2023 |
| | | | | JP | 2024-040204 | A | 25 March 2024 |
| | | | | JP | 7423583 | B2 | 29 January 2024 |
| | | | | US | 2023-0093809 | A1 | 30 March 2023 |
| KR | 10-2022-0128828 | A | 22 September 2022 | KR | 10-2573964 | B1 | 01 September 2023 |
| KR | 10-2010-0019249 | A | 18 February 2010 | BR | PI0912066 | A2 | 05 January 2016 |
| | | | | BR | PI0912066 | B1 | 08 October 2019 |
| | | | | CN | 102119338 | A | 06 July 2011 |
| | | | | CN | 102119338 | B | 21 August 2013 |
| | | | | EP | 2321663 | A1 | 18 May 2011 |
| | | | | EP | 2321663 | B1 | 27 May 2015 |
| | | | | JP | 2011-530696 | A | 22 December 2011 |
| | | | | JP | 5269994 | B2 | 21 August 2013 |
| | | | | KR | 10-0970841 | B1 | 16 July 2010 |
| | | | | TW | 201007190 | A | 16 February 2010 |
| | | | | TW | I381182 | B | 01 January 2013 |
| | | | | US | 2010-0036626 | A1 | 11 February 2010 |
| | | | | US | 2012-0035873 | A1 | 09 February 2012 |
| | | | | US | 8046181 | B2 | 25 October 2011 |
| | | | | US | 8332169 | B2 | 11 December 2012 |
| | | | | WO | 2010-016647 | A1 | 11 February 2010 |
| US | 2020-0386820 | A1 | 10 December 2020 | CA | 3136621 | A1 | 15 October 2020 |
| | | | | CN | 114174846 | A | 11 March 2022 |
| | | | | CN | 114174846 | B | 03 October 2023 |
| | | | | EP | 3953718 | A1 | 16 February 2022 |
| | | | | EP | 3953718 | A4 | 11 January 2023 |
| | | | | EP | 3953718 | B1 | 05 June 2024 |
| | | | | JP | 2022-526030 | A | 20 May 2022 |
| | | | | KR | 10-2022-0043070 | A | 05 April 2022 |
| | | | | US | 11262412 | B2 | 01 March 2022 |
| | | | | WO | 2020-210788 | A1 | 15 October 2020 |

Form PCT/ISA/210 (patent family annex) (July 2022)

**EP 4 768 958 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240031857